(19) Europäisches Patentamt
European Patent Office
Office européen des brevets

(11) **EP 2 656 086 B1**

(12) **EUROPÄISCHE PATENTSCHRIFT**

(45) Veröffentlichungstag und Bekanntmachung des Hinweises auf die Patenterteilung:
**18.03.2015 Patentblatt 2015/12**

(51) Int Cl.:
*G01R 15/16* (2006.01)　　*G01R 31/312* (2006.01)
*G01R 29/12* (2006.01)　　*G01R 15/14* (2006.01)
*G01R 19/00* (2006.01)　　*G01R 19/155* (2006.01)
*G01R 19/165* (2006.01)　　*G01R 27/26* (2006.01)

(21) Anmeldenummer: **11714977.3**

(22) Anmeldetag: **14.04.2011**

(86) Internationale Anmeldenummer:
**PCT/EP2011/055957**

(87) Internationale Veröffentlichungsnummer:
**WO 2012/139651 (18.10.2012 Gazette 2012/42)**

(54) **VERFAHREN ZUM BERÜHRUNGSLOSEN BESTIMMEN EINES ELEKTRISCHEN POTENTIALS MIT EINER SCHWINGBEWEGLICH AUSGEBILDETEN ELEKTRODE SOWIE VORRICHTUNG**

METHOD FOR THE CONTACTLESS DETERMINATION OF AN ELECTRICAL POTENTIAL USING AN OSCILLATING ELECTRODE, AND DEVICE

PROCÉDÉ DE DÉTERMINATION SANS CONTACT D'UN POTENTIEL ÉLECTRIQUE AU MOYEN D'UNE ÉLECTRODE CONÇUE DE FAÇON OSCILLANTE ET DISPOSITIF ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**30.10.2013 Patentblatt 2013/44**

(73) Patentinhaber: **Siemens Aktiengesellschaft 80333 München (DE)**

(72) Erfinder:
• **SCHIMMER, Jürgen**
**90473 Nürnberg (DE)**
• **MAKUTH, Jens**
**90537 Feucht (DE)**
• **SCHEIBNER, Dirk**
**90473 Nürnberg (DE)**

(56) Entgegenhaltungen:
GB-A- 2 443 280　　US-A- 4 205 267
US-A- 5 473 244　　US-A1- 2003 038 638
US-A1- 2007 065 169　　US-A1- 2007 247 166

**Beschreibung**

Die Erfindung betrifft ein Verfahren und eine Vorrichtung zum berührungslosen Bestimmen eines elektrischen Potentials eines Objekts.

Es ist bekannt, den Stromfluss durch ein Objekt berührungslos zu messen. Dies kann über induktive Kopplung, den Hall-Effekt oder den GMR(Giant Magneto Resistance)-Effekt erfolgen. Um berührungslos elektrische Leistung messen zu können, ist jedoch neben der berührungslosen Strommessung auch ein Verfahren zur berührungslosen Potentialmessung erforderlich. Die berührungslose Potentialmessung, insbesondere hoher Spannungen, ist v.a. im Bereich Smart Metering, Smart Grid und Response-Demand-Strategien von besonderer Bedeutung.

Eine Möglichkeit hierfür bieten so genannte Elektrofeldmeter. Diese nutzen den Effekt der Influenz, um über die ermittelte elektrische Feldstärke auf die zu bestimmende Spannung schließen zu können. Dafür müssen jedoch der Abstand zwischen dem Objekt, dessen Potential bestimmt werden soll, und der Messelektrode des Elektrofeldmeters sowie das Material (Dielektrikum) zwischen Messelektrode und Objekt in der Messkapazität exakt bekannt sein. Um mit einem Elektrofeldmeter auch Gleichspannungen messen zu können, wird in der Regel zwischen der Messelektrode und dem Objekt ein Shutter (Feldblende) in Form eines Choppers (Flügelrad) eingesetzt.

Für die Bestimmung reiner Wechselspannungen sind auch kapazitive Spannungsteiler nutzbar, wobei hier ebenfalls die Koppelkapazität zwischen einer Referenzelektrode und dem zu messenden Potential bekannt sein muss.

Beide Verfahren bzw. Vorrichtungen (Elektrofeldmeter und kapazitiver Spannungsteiler) setzen eine genaue Kenntnis der Ankopplung an die zu messende Spannung voraus, insbesondere des Abstands zwischen Messelektrode und Messobjekt. Insofern sind diese bekannten Verfahren für nur temporäre Messvorgänge oder nachträgliche Messinstallationen ungeeignet. Elektrofeldmeter und kapazitive Spannungsteiler werden für präzise Messungen fest installiert und in der Einbauumgebung kalibriert. Bei Handmessgeräten ist eine exakte Kenntnis der Geometrie und stofflichen Beschaffenheit (Leitungsisolation, Luft, Gas, Betauung, etc.) des Messaufbaus nötig. Dazu werden bei handelsüblichen Elektrofeldmetern zum Beispiel spezielle Abstandshalter benutzt. Abstandshalter haben jedoch den Nachteil, dass sie insbesondere für die Potentialbestimmung elektrisch isolierter Leitungen nicht direkt auf dem leitenden Material aufsitzen und damit den Abstand nur unzureichend genau einstellen. Zudem kann die Art des isolierenden Materials nicht berücksichtigt werden. Reicht diese Präzision der bekannten berührungslosen Potentialmessverfahren nicht aus, muss üblicherweise kontaktierend gemessen werden.

Die US 4 205 267 A offenbart einen berührungslosen Spannungssensor. Der Sensor umfasst eine erste und eine zweite Elektrode, die bezüglich einer Oberfläche bewegt werden können. Zwischen den Elektroden und einem Objekt, dessen Potential bestimmt werden soll, ist eine Blende angeordnet. Damit können sowohl statische als auch dynamische Anteile des Potentials des Objekts ermittelt werden.

Des Weiteren beschreibt die US 2007/065169 A1 eine Vorrichtung zum Messen eines elektrischen Potentials mit einer Elektrode. Die Vorrichtung umfasst einen Modulator zum Verändern der Kapazität zwischen der Elektrode und einem Objekt durch mechanische Vibrationen und einen Ladungsdetektor zum Erfassen der in die Elektrode induzierten elektrischen Ladung.

Die GB 2 443 280 A beschreibt eine Vorrichtung zum Messen eines Potentialunterschieds zwischen einer ersten und einer zweiten Oberfläche, die durch einen Isolator getrennt sind. Die Vorrichtung umfasst zumindest zwei Bereiche, mit denen das elektrische Potential unabhängig voneinander erfasst werden kann.

Schließlich beschreibt die US 2007/247166 A1 eine Messeinrichtung zum Bestimmen eines Potentials. Die Messeinrichtung umfasst eine Detektionselektrode aus einem leitenden Material, die zu einem Objekt anordnenbar ist, eine bewegliche Struktur, die aus zumindest zwei Materialien mit unterschiedlichen Dielektrizitätskonstanten besteht, und einen Antriebsmechanismus zum Bewegen der beweglichen Struktur und zum Messen des elektrischen Potentials des Objektes.

Es ist Aufgabe der Erfindung, ein Verfahren sowie eine Vorrichtung bereitzustellen, mit denen eine berührungslose Potentialmessung auch bei zunächst unbekannter Koppelkapazität möglich ist.

Diese Aufgabe wird durch ein Verfahren, welches die Merkmale des Patentanspruchs 1 aufweist, sowie eine Vorrichtung, welche die Merkmale des Patentanspruchs 7 aufweist, gelöst.

Das erfindungsgemäße Verfahren dient zum berührungslosen Bestimmen eines elektrischen Potentials eines Objekts und umfasst die folgenden Schritte:

a) Bereitstellen einer mechanisch schwingbeweglich ausgebildeten Elektrode, welche von dem Objekt räumlich beabstandet ist;
b) Versetzen der Elektrode in mechanische Schwingung;
c) Bestimmen einer zeitlichen Veränderung eines elektrischen Ladezustands der Elektrode;
d) Ermitteln von Amplituden von zumindest zwei Frequenzkomponenten in der zeitlichen Veränderung des elektrischen Ladezustands;
e) Bestimmen zumindest eines Parameters, welcher in den Wert einer elektrischen Kapazität der Anordnung aus Elektrode und Objekt eingeht, mittels der ermittelten Amplituden;

f) Ermitteln der elektrischen Kapazität der Anordnung aus Elektrode und Objekt anhand des bestimmten Parameters;

g) Ermitteln des elektrischen Potentials aus der bestimmten Veränderung des elektrischen Ladezustands und der ermittelten Kapazität;

d1) Bestimmen einer ersten Amplitude bei einer ersten Frequenz;

d2) Bestimmen einer zweiten Amplitude bei einer zweiten Frequenz, deren Wert ein ganzzahliges Vielfaches des Werts der ersten Frequenz ist; und

e1) Bestimmen eines Ruheabstands der Elektrode zu dem Objekt aus dem Verhältnis der ersten zur zweiten Amplitude.

Im Rahmen des Verfahrens kann also die Koppelkapazität zwischen der Elektrode und dem Objekt unmittelbar bestimmt werden, sodass insbesondere keine vorherige Kenntnis oder Festeinstellung dieser Kapazität für die Potentialmessung erforderlich ist. Der eigentlichen Potentialmessung geht damit im Rahmen des Verfahrens quasi ein Kalibrierschritt voraus, durch den unbekannte Parameter ermittelt werden können, welche erforderlich sind, um die Koppelkapazität zu bestimmen. Im Unterschied zum Einsatz von Elektfeldmetern oder kapazitiven Spannungsteilern ist beim Einsatz der beschriebenen Methode kein Wissen über den Abstand der Elektrode von dem Objekt bzw. kein Wissen über die Dielektrizitätskonstante des Materials zwischen der Elektrode und dem Objekt bei berührungsloser Potentialmessung erforderlich. Eine exakte mechanische Justage bzw. ein definierter Festeinbau eines Messgeräts entfällt. Im Rahmen des Verfahrens kann die Kapazität exakt bestimmt werden. Damit sind sehr präzise berührungslose Messungen des unbekannten Potentials möglich.

Bei der Frequenz kann es sich insbesondere um jene Frequenz handeln, welche die zeitliche Veränderung des elektrischen Ladezustands der Elektrode charakterisiert. Besonders bevorzugt ist es, die zweite Amplitude bei einer zweiten Frequenz zu bestimmen, deren Wert doppelt so groß ist wie der Wert der ersten Frequenz. Alternativ zur Bestimmung des Ruheabstands kann aus dem Verhältnis der ersten zur zweiten Amplitude auch ein mit einer Dielektrizitätskonstante gewichteter effektiver Ruheabstandswert bestimmt werden. Besonders bevorzugt ist es, die zeitliche Veränderung des elektrischen Ladezustands über ein vorgegebenes Zeitintervall hinweg zu bestimmen und an dem so bestimmten Verlauf eine Fourier-Analyse durchzuführen. Aus der Fourier-Analyse können sich dann vorzugsweise die von den Frequenzkomponenten abhängigen Amplituden ergeben, sodass eine erste Amplitude bei einer Grundfrequenz und die zweite Amplitude bei einer hierzu korrespondierenden Oberfrequenz ermittelbar und daraus das Verhältnis bestimmbar ist. Diese Art der Messung ist vergleichsweise einfach und erlaubt exakte Rückschlüsse auf den Ruheabstand der Elektrode zu dem Objekt. Eine direkte Abstandsmessung, beispielsweise über mechanische Abstandshalter, ist nicht erforderlich. Der Kalibriervorgang ist insgesamt einfach und aufwandsarm. Eine direkte Kontaktierung des Objekts, dessen Potential bestimmt werden soll, ist im Rahmen des Verfahrens nicht erforderlich. Damit kann auch das Potential von schwer zugänglichen Objekten bestimmt werden.

Vorzugsweise erfolgt in Schritt e) das Bestimmen des zumindest einen Parameters über einen mathematischen Zusammenhang und/oder eine Kalibrierkurve. Dann ist lediglich eine Eichmessung erforderlich, über welche die Kalibrierkurve bzw. der mathematische Zusammenhang bestimmt wird, und es kann den Amplitudenwerten eindeutig der zumindest eine Parameter zugeordnet werden.

Vorzugsweise wird in Schritt b) die Elektrode so in mechanische Schwingung versetzt, dass ihre Schwingungsrichtung parallel zu einer elektrischen Feldlinie verläuft, welche durch das elektrische Potential des Objekts verursacht wird. Dann ist sehr definierte physikalische Situation geschaffen und die Bestimmung der Koppelkapazität zwischen Objekt und Elektrode kann sehr einfach erfolgen. Es werden sehr präzise Messungen möglich.

Vorzugsweise erfolgt in Schritt c) das Bestimmen der zeitlichen Veränderung des elektrischen Ladezustands der Elektrode durch Messung eines Umladestroms. Hierfür kann ein Bezugspotentialträger mit der Elektrode elektrisch verbunden sein und zwischen der Elektrode und dem Bezugspotentialträger ein Strommessgerät angeordnet sein. Besonders bevorzugt ist eine Anordnung unter Verwendung eines Verstärkers, mittels dessen die an der Elektrode abfallende Spannung mit einer vorgebbaren Referenzspannung verglichen wird. Strommessungen sind sehr präzise durchführbar und erlauben demgemäß sehr genaue Rückschlüsse auf das zu bestimmende elektrische Potential. Besonders bevorzugt kann für das Ermitteln des elektrischen Potentials ein effektiver Umladestrom bestimmt werden.

Vorzugsweise wird in Schritt g) das elektrische Potential über einen mathematischen Zusammenhang und/oder eine Kalibrierkurve aus der bestimmten Veränderung des elektrischen Ladezustands ermittelt.

Das Verfahren erlaubt die Bestimmung eines zeitlich konstanten Potentials an dem Objekt. Bereits durch die Schwingung der Elektrode wird eine zeitlich veränderliche Ladezustandsänderung an der Elektrode geschaffen, welche gemessen werden kann. Vorzugsweise kann mittels des Verfahrens jedoch auch ein elektrisches Potential des Objekts bestimmt werden, das zeitlich veränderlich ist und durch eine elektrische Schwingungsfrequenz charakterisierbar ist. Die Elektrode in Schritt b) wird dabei vorzugsweise so in mechanische Schwingung versetzt, dass die zugehörige mechanische Schwingungsfrequenz größer als die elektrische Schwingungsfrequenz ist. Besonders bevorzugt ist ein sehr hohes Verhältnis der mechanischen Schwingungsfrequenz zur elektrischen Schwingungsfrequenz. Dann sieht die Elektrode quasi ein zeitlich konstantes Potential an dem Objekt und es kann eine entkoppelte Betrachtung durchgeführt werden. Sowohl für AC- als auch DC-Messungen wird dann kein Shutter bzw. Flügelrad benötigt.

Eine erfindungsgemäße Vorrichtung dient zur berührungslosen Bestimmung eines elektrischen Potentials eines Objekts und umfasst:

- eine mechanisch schwingbeweglich ausgebildete Elektrode, welche von dem Objekt räumlich beabstandet anordenbar ist;
- eine Messvorrichtung, welche dazu ausgebildet ist, eine zeitliche Veränderung eines elektrischen Ladezustands der Elektrode zu bestimmen; und
- eine Auswertevorrichtung, welche dazu ausgebildet ist, Amplituden von zumindest zwei Frequenzkomponenten in der zeitlichen Veränderung des elektrischen Ladezustands zu ermitteln, zumindest einen Parameter, welcher in den Wert einer elektrischen Kapazität der Anordnung aus Elektrode und Objekt eingeht, mittels der ermittelten Amplituden zu bestimmen, die elektrische Kapazität der Anordnung aus Elektrode und Objekt anhand des bestimmten Parameters zu ermitteln, und das elektrische Potential aus der bestimmten Veränderung des elektrischen Ladezustands und der ermittelten Kapazität zu ermitteln, wobei die Auswertevorrichtung dazu ausgebildet ist, eine erste Amplitude bei einer ersten Frequenz und eine zweite Amplitude bei einer zweiten Frequenz, deren Wert ein ganzzahliges Vielfaches des Werts der ersten Frequenz ist, zu bestimmen und einen Ruheabstand der Elektrode zu dem Objekt aus dem Verhältnis der ersten zur zweiten Amplitude zu bestimmen.

Vorzugsweise ist die Elektrode als elektrisch leitfähige Platte ausgebildet, welche im Wesentlichen in Richtung der Plattennormalen schwingbeweglich ist, wobei die Platte vorzugsweise elektrisch mit der Messvorrichtung verbunden ist, welche als Strommessgerät ausgebildet ist.

Die mit Bezug auf das erfindungsgemäße Verfahren dargestellten bevorzugten Ausführungsformen und deren Vorteile gelten entsprechend für die erfindungsgemäße Vorrichtung.

Anhand von Ausführungsbeispielen wird die Erfindung im Folgenden näher erläutert. Es zeigen:

FIG 1       eine schematische Darstellung einer Vorrichtung zur Messung eines unbekannten Potentials einer Leitung;

FIG 2       die Abhängigkeit eines effektiven Umladestroms vom Ruheabstand der Messelektrode vom Leiter;

FIG 3A       die Abhängigkeit eines Umladestroms von der Zeit für zwei verschiedene Abstände der Messelektrode von der Leitung;

FIG 3B       ein über Fouriertransformation aus den Kurven der FIG 3A erhaltenes Amplitudenspektrum;

FIG 4       eine Kalibrationskurve, welche jedem Amplitudenverhältnis des Amplitudenspektrums der FIG 3B einen Ruheabstand zuordnet; und

FIG 5       eine Kalibrationskurve, welche jedem effektiven Stromwert einen Spannungswert der Leitung zuordnet.

In den Figuren sind gleiche oder funktionsgleiche Elemente mit den gleichen Bezugszeichen versehen.

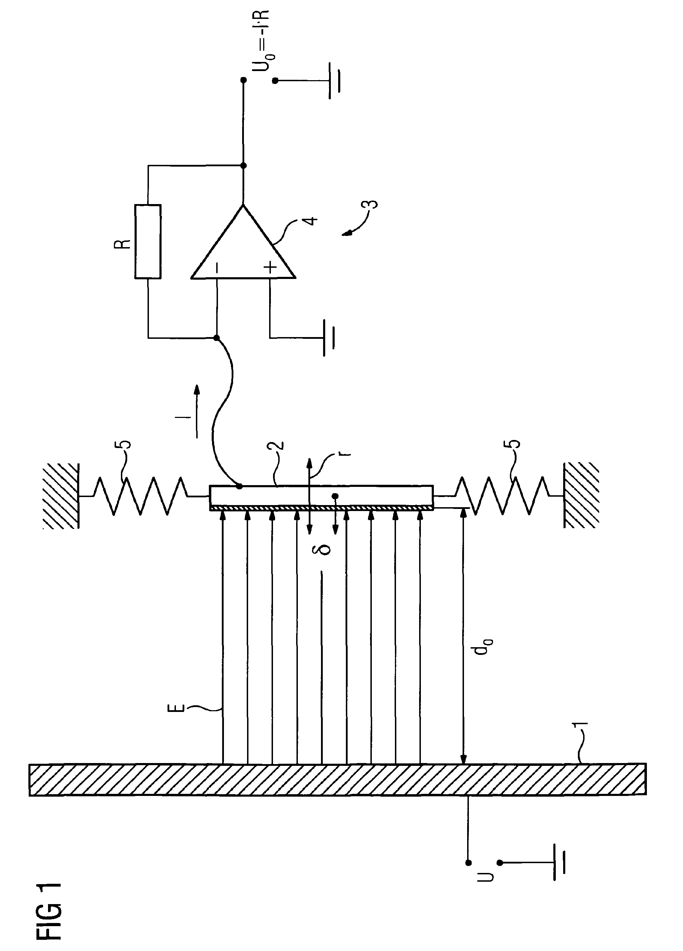

FIG 1 zeigt eine Leitung 1, welche ein Objekt darstellt, dessen elektrisches Potential bzw. Spannung U bestimmt werden soll. Hierfür ist im Ruheabstand $d_0$ eine Messelektrode 2 angeordnet, welche schwingbeweglich ausgebildet ist. Die Fähigkeit zur Schwingung wird hier, nur schematisch dargestellt, über zwei Federn 5 ermöglicht. Diese Anordnung erlaubt eine mechanische Schwingung der Messelektrode 2 in Schwingungsrichtung r und damit in eine Richtung, welche parallel zur Flächennormalen der Messelektrode 2 verläuft. Die Messelektrode 2 ist aus einem Metall ausgebildet, sodass sich aufgrund von Influenz im elektrischen Feld E der Leitung 1 eine Änderung des Ladezustands der Messelektrode 2 ergibt. Diese Umladung kann über die Messung eines Umladestroms I erfasst werden. Der Umladestrom I wird hierbei von einer Messvorrichtung 3 erfasst, welche einen Bezugspotentialträger darstellt.

Die Messvorrichtung 3 umfasst einen Verstärker 4 mit einem ersten Eingang, welcher mit der Messelektrode 2 elektrisch verbunden ist, und einen zweiten Eingang, welcher geerdet ist. Ein Ausgang des Verstärkers 4 ist über einen elektrischen Widerstand R mit dem ersten Eingang elektrisch verbunden.

Im Rahmen des Messverfahrens wird die Messelektrode 2 in mechanische Schwingung in Schwingungsrichtung r mit der Frequenz f versetzt. Es ergeben sich die folgenden physikalischen Zusammenhänge:

Durch die Leitung 1 und die Messelektrode 2 ist eine Plattenkondensatoranordnung mit einer Koppelkapazität C geschaffen. Die Kapazität C berechnet sich gemäß

$$C = \frac{\varepsilon \cdot A}{d}$$

- $\varepsilon$ ist hierbei die Dielektrizitätskonstante des die Kondensatoranordnung ausfüllenden Mediums;
- A ist die Fläche der Messelektrode 2; und
- d ist der zeitabhängige Abstand zwischen der Messelektrode 2 und der Leitung 1.

Mit der Kreisfrequenz

$$\omega = 2\pi f$$

ergibt sich für die Kapazität C:

$$C(t) = \frac{\varepsilon \cdot A}{d(t)} = \frac{\varepsilon \cdot A}{d_0 + \delta \cdot \sin(\omega t)}$$

Der jeweils fließende Umladestrom I beträgt folglich:

$$I = U \cdot dC / dt = U \cdot \varepsilon \cdot A \cdot \frac{-\delta \cdot \cos \omega t}{(d_0 + \delta \cdot \sin \omega t)^2} = U \cdot \varepsilon \cdot A \cdot \frac{-\delta \cdot \cos \omega t}{d_0 + 2d_0\delta \cdot \sin \omega t + \frac{1}{2} - \frac{\cos 2\omega t}{2}}$$

Die Modulation der Messkapazität C zwischen Messelektrode 2 und Leitung 1 führt zu dem Umladestrom I, der im Rahmen einer Auswertung in zweifacher Hinsicht herangezogen wird. Einerseits wird er im Rahmen eines Kalibrierschritts verwendet, um die unbekannte Kapazität C zu bestimmen; andererseits wird sein Effektivwert herangezogen, um mittels der im Kalibrierschritt ermittelten Kapazität die unbekannte Spannung U zu bestimmen. Dies sei im Folgenden näher erläutert.

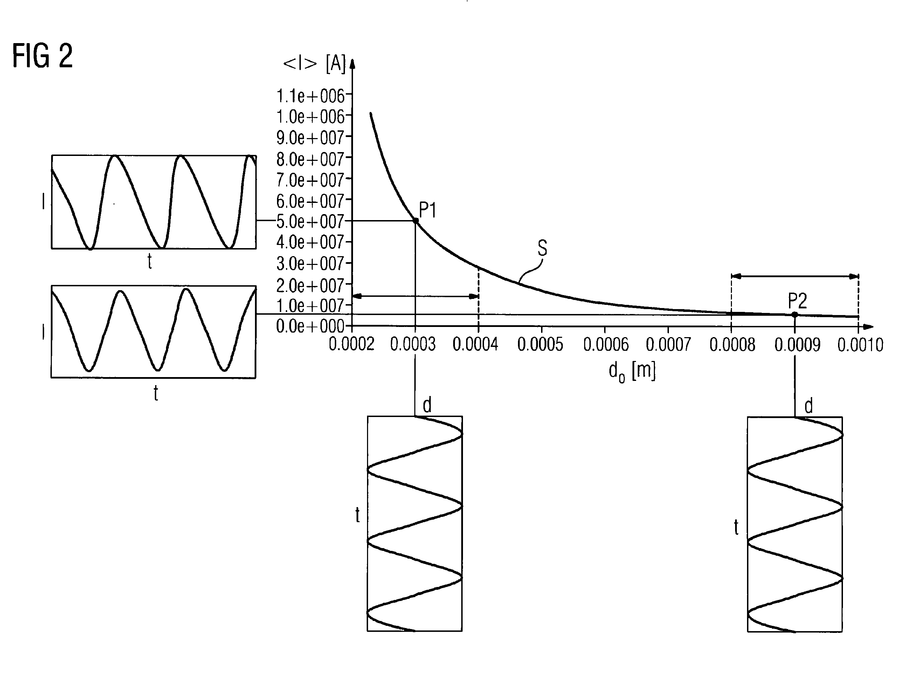

FIG 2 zeigt ein Diagramm mit einer Kurve S. Diese stellt den Zusammenhang zwischen dem effektiven Umladestrom <I> und dem Ruheabstand $d_0$ dar. Es sind exemplarisch zwei Punkte P1 und P2 auf der Kurve S eingezeichnet. Am Punkt P1 beträgt der Ruheabstand $d_0$=0,3 mm, während er am Punkt P2 $d_0$=0,9 mm beträgt. Der effektive Umladestrom <I> ist demgemäß am Punkt P1 größer als am Punkt P2.

Für die Punkte P1 und P2 sind dann jeweils auch die zeitabhängigen Strom- und Abstandsverläufe in FIG 2 dargestellt. Wie man einem Vergleich der Stromverläufe in den Punkten P1 und P2 entnehmen kann, ist am Punkt P1 die zum zeitabhängigen Umladestrom I gehörige Kurve stärker verzerrt als am Punkt P2. Bei geringer werdendem Grundabstand bzw. Ruheabstand $d_0$ wird also die Signalform des Umladestroms I zunehmend verzerrt. Dieser Effekt kann dazu genutzt werden, den Ruheabstand $d_0$ zu bestimmen.

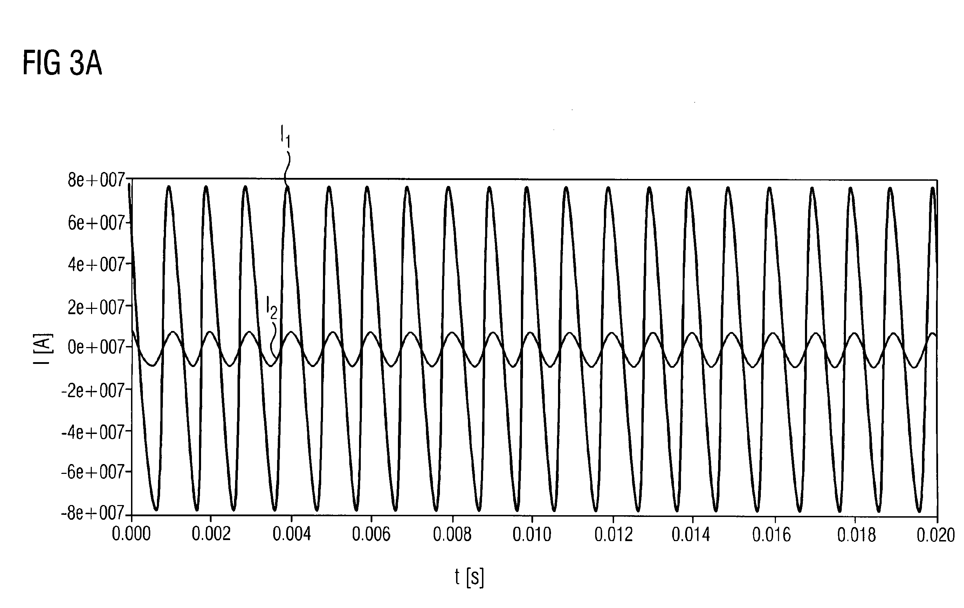

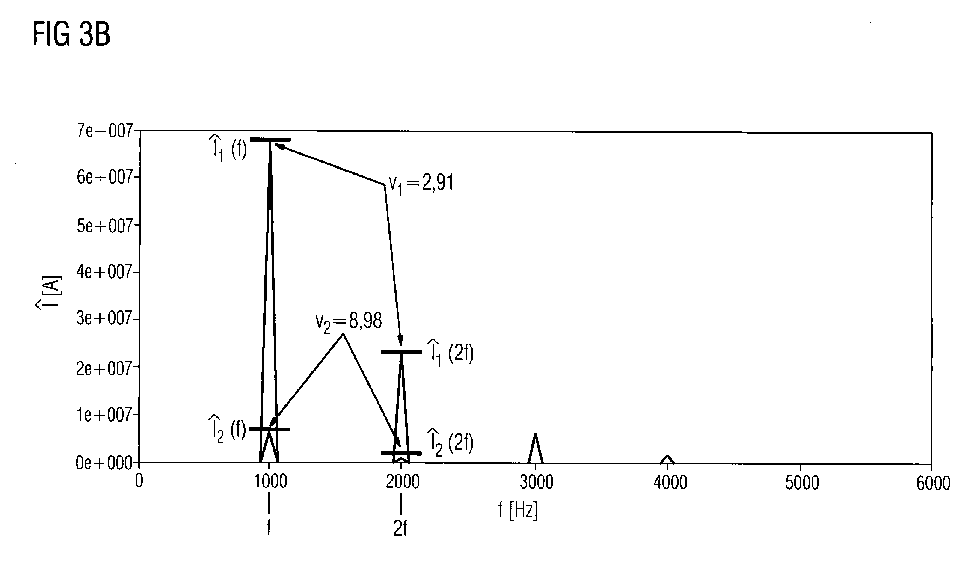

Das Zeitverhalten der Umladeströme ist nochmals in FIG 3A zusammengestellt. Der von der Zeit t abhängige Umladestrom am Punkt P1 sei mit $I_1$ bezeichnet, während der Umladestrom am Punkt P2 mit $I_2$ bezeichnet ist. An den Umladestromverläufen $I_1$ und $I_2$ wird nun eine Fast-Fouriertransformation (FFT) durchgeführt. Hierdurch ergibt sich das in FIG 3B dargestellte Amplitudenspektrum für den Umladestrom. Auf der Abszisse ist die Frequenz f in Hertz angetragen, während auf der Ordinate die Amplitude des Umladestroms Î in Ampere dargestellt ist. Der Umladestrom $I_1$ weist mehrere Frequenzkomponenten auf. Die Amplitude bei der Grundfrequenz f=1000 Hz sei mit $\hat{I}_1(f)$ bezeichnet; bei der ersten Oberfrequenz 2f=2000 Hz beträgt die Amplitude $\hat{I}_1(2f)$. Das Verhältnis dieser beiden Amplituden berechnet sich gemäß

$$v_1 = \frac{\hat{I}_1(f)}{\hat{I}_1(2f)}$$

und beträgt $v_1$=2,91.

Ebenso kann für den Umladestrom $I_2$ in FIG 3A verfahren werden. Auch an seinem zeitabhängigen Verlauf kann eine Fourier-Analyse durchgeführt werden, sodass sich ein ebenfalls in FIG 3B dargestelltes Amplitudenspektrum mit den Amplituden $\hat{I}_2(f)$ und $\hat{I}_2(2f)$ ergibt. Auch hier berechnet sich das Amplitudenverhältnis gemäß

$$v_2 = \frac{\hat{I}_2(f)}{\hat{I}_2(2f)},$$

sodass sich der Wert $v_2$=8,98 einstellt. Betrachtet man die in FIG 3B dargestellten Spektren für die beiden Ruheabstände 0,3 mm und 0,9 mm, so erkennt man, dass die Oberwellen mit zunehmendem Ruheabstand $d_0$ geringer werden. Das Verhältnis von Grund- zu erster Oberwelle nimmt entsprechend zu.

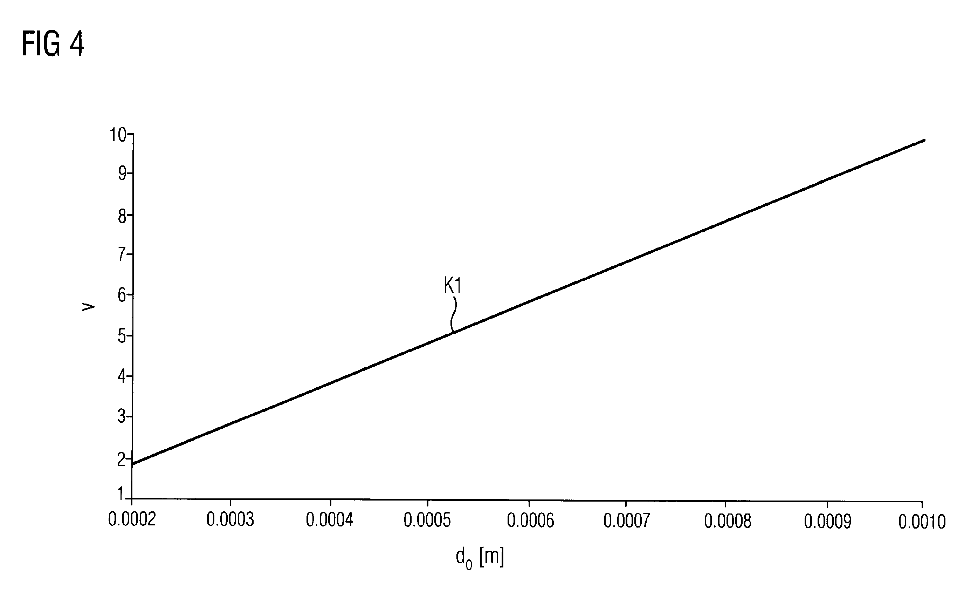

Diesem Verhältnis v kann nunmehr über eine Kalibrierkurve eindeutig ein Ruheabstand $d_0$ zugeordnet werden. Dies ist für eine Kalibrationskurve K1 in FIG 4 dargestellt. Es besteht ein linearer Zusammenhang zwischen dem Verhältnis v und dem Ruheabstand $d_0$. Damit ist ein Rückschluss von v auf $d_0$ möglich. Dieses Verhältnis ist zudem vom unbekannten Potential unabhängig. Die Auswertung dieses Verhältnisses dient zur Kalibrierung im Rahmen des Messverfahrens. Gegebenenfalls kann statt des Ruheabstands $d_0$ auf der Abszisse auch ein mit der Dielektrizitätskonstante $\varepsilon$ gewichteter Abstand, z.B. ein Abstand der Form $d_0/\varepsilon$, aufgetragen sein. Mit der Bestimmung des Ruheabstands $d_0$ kann nunmehr bei bekannter Dielektrizitätskonstante $\varepsilon$ und bekannter Fläche A auf die Kapazität C rückgeschlossen werden. Damit ist prinzipiell eine Bestimmung der Spannung U aus dem gemessenen Umladestrom I möglich. Der Kalibrierschritt im Rahmen des Verfahrens ist damit abgeschlossen.

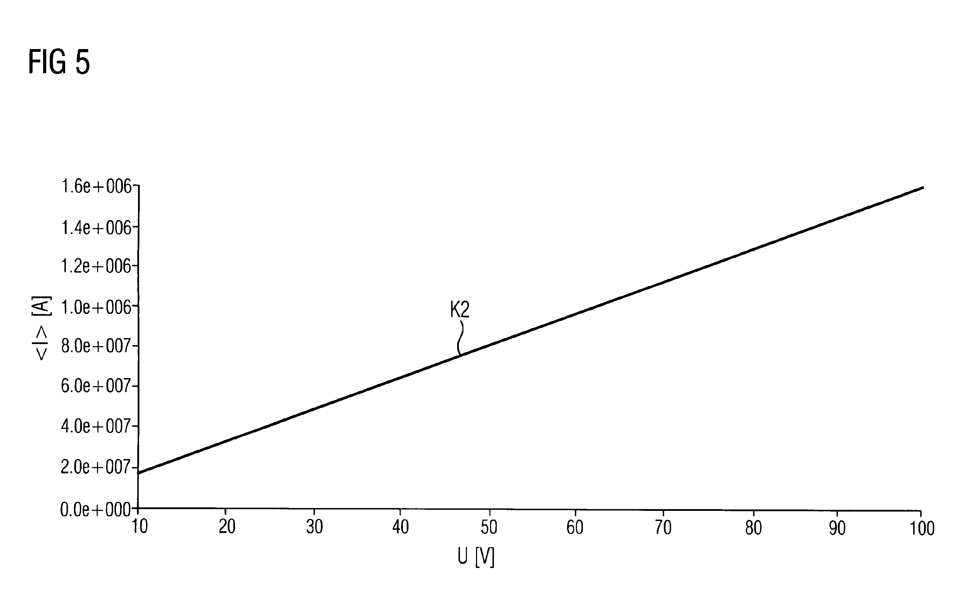

Im eigentlichen Messbetrieb wird dann beispielsweise der Effektivwert <I> des Umladestroms I gebildet. Da ein linearer Zusammenhang des effektiven Umladestroms <I> zum unbekannten Potential U besteht, kann über eine Kalibrierkurve K2 direkt auf das unbekannte Potential U geschlossen werden. Dieser Zusammenhang ist in FIG 5 dargestellt.

Im Ausführungsbeispiel der FIG 2 bis 5 wurden folgende Annahmen getroffen: Frequenz f=1kHz; Schwingungsamplitude $\delta$=100$\mu$m; und Fläche A=100mm$^2$.

Die beiden Teilschritte des Messverfahrens seien nochmals zusammengefasst:

1. In einem Kalibrierschritt wird die Messelektrode 2 vor der Leitung 1 positioniert. Der Ruheabstand $d_0$ ist nach der Installation nicht exakt bekannt; eine Kalibrierung ist nötig. Hierfür wird die Messelektrode 2 in Schwingung versetzt und der Umladestrom I in der schwingenden Messelektrode 2 spektral ausgewertet. Man betrachtet die Amplituden $\hat{I}(f)$ bzw. $\hat{I}(2f)$ an der Schwingfrequenz f und an der ersten Oberwelle 2f. Das Verhältnis v der Amplitude $\hat{I}(f)$ der Grundfrequenz zur Amplitude $\hat{I}(2f)$ der ersten Oberwelle ist dabei direkt proportional zum Ruheabstand $d_0$ und unabhängig von der unbekannten Spannung U. Das Verfahren ermöglicht damit eine Bestimmung des Grundabstands bzw. Ruheabstands $d_0$.

2. In einem Messschritt wird der Effektivwert <I> des Umladestroms I an der schwingenden Messelektrode 2 gebildet. Es besteht ein proportionaler Zusammenhang zwischen dem Umladestrom <I> an der Messelektrode 2 und dem unbekannten Potential U. Der zugehörige Proportionalitätsfaktor (typischerweise die Kapazität C) wird vorab im Kalibrierschritt 1 bestimmt.

Das Verfahren erlaubt folglich eine berührungslose Messung unbekannter Potentiale mit einer schwingenden Elektrode, welche sich transversal zum unbekannten Potential bewegt. Die Schwingfrequenz liegt dabei deutlich höher als die größte zu messende Frequenz einer zeitlich abhängigen Spannung U(t). Weiterhin werden die an der schwingenden Messelektrode 2 auftretenden Umladeströme I spektral ausgewertet, um den Grundabstand $d_0$ zwischen Messelektrode 2 und Messobjekt (Leitung 1) zu bestimmen. Nach dieser Kalibrierung wird im Messbetrieb der Umladestrom I zur Rückrechnung auf das unbekannte Potential U benutzt.

Bezugszeichenliste

| | |
|---|---|
| 1 | Leitung |
| 2 | Messelektrode |
| 3 | Messvorrichtung |
| 4 | Verstärker |
| 5 | Feder |
| d | Abstand |
| $d_0$ | Ruheabstand |
| $\delta$ | Schwingungsamplitude |
| U | Spannung |
| I, $I_1$, $I_2$ | Umladestrom |
| I, $\hat{I}_1$, $\hat{I}_2$ | Amplitude des Umladestroms |
| \<I\> | effektiver Umladestrom |
| f | Frequenz |
| C | Kapazität |
| v, $v_1$, $v_2$ | Verhältnis |
| $\varepsilon$ | Dielektrizitätskonstante |
| K1 | Kurve |
| K2 | Kurve |
| S | Kurve |
| P1 | Punkt |
| P2 | Punkt |
| r | Schwingungsrichtung |
| E | elektrisches Feld |
| $U_0$ | Spannung |
| R | Widerstand |
| t | Zeit |
| A | Fläche |
| $\omega$ | Kreisfrequenz |

**Patentansprüche**

1. Verfahren zum berührungslosen Bestimmen eines elektrischen Potentials (U) eines Objekts (1) mit den Schritten:

a) Bereitstellen einer mechanisch schwingbeweglich ausgebildeten Elektrode (2), welche von dem Objekt (1) räumlich beabstandet ($d_0$) ist;
b) Versetzen der Elektrode (2) in mechanische Schwingung (f);
c) Bestimmen einer zeitlichen Veränderung eines elektrischen Ladezustands der Elektrode (I);
d) Ermitteln von Amplituden ($\hat{I}(f)$, $\hat{I}(2f)$) von zumindest zwei Frequenzkomponenten (f, 2f) in der zeitlichen Veränderung des elektrischen Ladezustands (I);
e) Bestimmen zumindest eines Parameters ($\varepsilon$, $d_0$), welcher in den Wert einer elektrischen Kapazität (C) der Anordnung aus Elektrode (2) und Objekt (1) eingeht, mittels der ermittelten Amplituden ($\hat{I}(f)$, $\hat{I}(2f)$);
f) Ermitteln der elektrischen Kapazität (C) der Anordnung aus Elektrode (2) und Objekt (1) anhand des bestimmten Parameters ($\varepsilon$, $d_0$); und
g) Ermitteln des elektrischen Potentials (U) aus der bestimmten Veränderung des elektrischen Ladezustands (I) und der ermittelten Kapazität (C);

**gekennzeichnet durch** die Schritte:

d1) Bestimmen einer ersten Amplitude ($\hat{I}(f)$) bei einer ersten Frequenz (f);
d2) Bestimmen einer zweiten Amplitude ($\hat{I}(2f)$) bei einer zweiten Frequenz (2f), deren Wert ein ganzzahliges Vielfaches des Werts der ersten Frequenz (f) ist; und

e1) Bestimmen eines Ruheabstands ($d_0$) der Elektrode (2) zu dem Objekt (1) aus dem Verhältnis (v) der ersten ($\hat{I}(f)$) zur zweiten Amplitude ($\hat{I}(2f)$).

2. Verfahren nach Anspruch 1, **dadurch gekennzeichnet, dass** in Schritt e) das Bestimmen des zumindest einen Parameters ($\varepsilon$, $d_0$) über einen mathematischen Zusammenhang und/oder eine Kalibrierkurve (K1) erfolgt.

3. Verfahren nach einem der vorhergehenden Ansprüche, **dadurch gekennzeichnet, dass** in Schritt b) die Elektrode (2) so in mechanische Schwingung versetzt wird, dass ihre Schwingungsrichtung (r) parallel zu einer elektrischen Feldlinie (E) verläuft, welche durch das elektrische Potential (U) des Objekts (1) verursacht wird.

4. Verfahren nach einem der vorhergehenden Ansprüche, **dadurch gekennzeichnet, dass** in Schritt c) das Bestimmen der zeitlichen Veränderung des elektrischen Ladezustands der Elektrode (2) durch Messung eines Umladestroms (I) erfolgt.

5. Verfahren nach einem der vorhergehenden Ansprüche, **dadurch gekennzeichnet, dass** in Schritt g) das elektrische Potential (U) über einen mathematischen Zusammenhang und/oder eine Kalibrierkurve (K2) aus der bestimmten Veränderung des elektrischen Ladezustands (I) ermittelt wird.

6. Verfahren nach einem der vorhergehenden Ansprüche, **dadurch gekennzeichnet, dass** das elektrische Potential (U) zeitlich veränderlich ist und durch eine elektrische Schwingungsfrequenz charakterisierbar ist, und die Elektrode (2) in Schritt b) so in mechanische Schwingung versetzt wird, dass die zugehörige mechanische Schwingungsfrequenz (f) größer als die elektrische Schwingungsfrequenz ist.

7. Vorrichtung zur berührungslosen Bestimmung eines elektrischen Potentials (U) eines Objekts (1) mit:

- einer mechanisch schwingbeweglich ausgebildeten Elektrode (2), welche von dem Objekt (1) räumlich beabstandet ($d_0$) anordenbar ist;
- einer Messvorrichtung (3), welche dazu ausgebildet ist, eine zeitliche Veränderung eines elektrischen Ladezustands (I) der Elektrode (2) zu bestimmen; und
- einer Auswertevorrichtung, welche dazu ausgebildet ist, Amplituden ($\hat{I}(f)$, $\hat{I}(2f)$) von zumindest zwei Frequenzkomponenten (f, 2f) in der zeitlichen Veränderung des elektrischen Ladezustands (I) zu ermitteln, zumindest einen Parameter ($\varepsilon$, $d_0$), welcher in den Wert einer elektrischen Kapazität (C) der Anordnung aus Elektrode (2) und Objekt (1) eingeht, mittels der ermittelten Amplituden ($\hat{I}(f)$, $\hat{I}(2f)$) zu bestimmen, die elektrische Kapazität (C) der Anordnung aus Elektrode (2) und Objekt (1) anhand des bestimmten Parameters ($\varepsilon$, $d_0$) zu ermitteln, und das elektrische Potential (U) aus der bestimmten Veränderung des elektrischen Ladezustands (I) und der ermittelten Kapazität (C) zu ermitteln,

**dadurch gekennzeichnet, dass**

- die Auswertevorrichtung dazu ausgebildet ist, eine erste Amplitude ($\hat{I}(f)$) bei einer ersten Frequenz (f) und eine zweite Amplitude ($\hat{I}(2f)$) bei einer zweiten Frequenz (2f), deren Wert ein ganzzahliges Vielfaches des Werts der ersten Frequenz (f) ist, zu bestimmen und einen Ruheabstand ($d_0$) der Elektrode (2) zu dem Objekt (1) aus dem Verhältnis (v) der ersten ($\hat{I}(f)$) zur zweiten Amplitude ($\hat{I}(2f)$) zu bestimmen.

8. Vorrichtung nach Anspruch 7, **dadurch gekennzeichnet, dass** die Elektrode (2) als elektrisch leitfähige Platte ausgebildet ist, welche im Wesentlichen in Richtung (r) der Plattennormalen schwingbeweglich ist, und die Platte elektrisch mit der Messvorrichtung (3) verbunden ist, welche als Strommessgerät ausgebildet ist.

**Claims**

1. Method for the contactless determination of an electrical potential (U) of an object (1) with the steps:

a) providing a mechanically oscillating electrode (2), which is spatially distanced ($d_0$) from the object (1);
b) triggering the electrode (2) to oscillate (f) mechanically;
c) determining a temporal change in an electrical charge state of the electrode (I);
d) determining amplitudes ($\hat{I}(f)$, $\hat{I}(2f)$) of at least two frequency components (f, 2f) in the temporal change of the electrical charge state (I);

e) determining at least one parameter ($\varepsilon$, $d_0$), which is included in the value of an electrical capacitance (C) of the arrangement comprising electrode (2) and object (1), by means of the determined amplitudes ($\hat{I}(f)$, $\hat{I}(2f)$);

f) determining the electrical capacitance (C) of the arrangement comprising electrode (2) and object (1) with the aid of the determined parameter ($\varepsilon$, $d_0$) ; and

g) determining the electrical potential (U) from the determined change in the electrical charge state (I) and the determined capacitance (C);

**characterised by** the steps:

d1) determining a first amplitude ($\hat{I}(f)$) at a first frequency (f) ;

d2) determining a second amplitude ($\hat{I}(2f)$) at a second frequency (2f), the value of which is a whole number multiple of the value of the first frequency (f); and

e1) determining an idling distance ($d_0$) of the electrode (2) from the object (1) from the ratio (v) of the first ($\hat{I}(f)$) to the second amplitude ($\hat{I}(2f)$).

2. Method according to claim 1, **characterised in that** in step e), the at least one parameter ($\varepsilon$, $d_0$) is determined by way of a mathematical association and/or a calibration curve (K1).

3. Method according to one of the preceding claims, **characterised in that** in step b), the electrode (2) is mechanically oscillated such that its oscillation direction (r) runs in parallel to an electrical field line (E), which is caused by the electrical potential (U) of the object (1).

4. Method according to one of the preceding claims, **characterised in that** in step c), the temporal change in the electrical charge state of the electrode (2) is determined by measuring a changeover current (I).

5. Method according to one of the preceding claims, **characterised in that** in step g), the electrical potential (U) is determined by way of a mathematical association and/or a calibration curve (K2) from the determined change in the electrical charge state (I).

6. Method according to one of the preceding claims, **characterised in that** the electrical potential (U) is temporally changeable and can be **characterised by** an electrical oscillation frequency, and the electrode (2) in step b) is mechanically oscillated such that the associated mechanical oscillation frequency (f) is greater than the electrical oscillation frequency.

7. Apparatus for the contactless determination of an electrical potential (U) of an object (1) having:

- a mechanically oscillating electrode (2) which can be arranged spatially distanced ($d_0$) from the object (1);

- a measuring apparatus (3) which is embodied to determine a temporal change in an electrical charge state (I) of the electrode (2); and

- an evaluation apparatus, which is embodied to determine amplitudes ($\hat{I}(f)$, $\hat{I}(2f)$) from at least two frequency components (f, 2f) in the temporal change in the electric charge state (I), at least one parameter ($\varepsilon$, $d_0$), which is included in the value of an electrical capacitance (C) of the arrangement comprising electrode (2) and object (1), by means of the determined amplitudes ($\hat{I}(f)$, $\hat{I}(2f)$), to determine the electrical capacitance (C) of the arrangement comprising electrode (2) and object (1) with the aid of the determined parameter ($\varepsilon$, $d_0$) and to determine the electrical potential (U) from the determined change in the electrical charge state (I) and the determined capacitance (C),

**characterised in that**

- the evaluation apparatus is embodied to determine a first amplitude ($\hat{I}(f)$) at a first frequency (f) and a second amplitude ($\hat{I}(2f)$) at a second frequency (2f), the value of which is a whole number multiple of the value of the first frequency (f) and to determine an idling distance ($d_0$) of the electrode (2) from the object (1) from the ratio (v) of the first ($\hat{I}(f)$) to the second amplitude ($\hat{I}(2f)$).

8. Apparatus according to claim 7, **characterised in that** the electrode (2) is embodied as an electrically conductive plate, which can essentially be oscillated in the direction (r) of the plate normal, and the plate is electrically connected to the measuring apparatus (3) which is embodied as a current measuring device.

**Revendications**

1. Procédé de détermination sans contact d'un potentiel électrique (U) d'un objet (1), comprenant les étapes suivantes :

   a) la fourniture d'une électrode (2) conçue en étant mécaniquement mobile en oscillation, électrode qui est physiquement à distance ($d_0$) de l'objet (1);
   b) le décalage de l'électrode (2) dans l'oscillation mécanique (f);
   c) la détermination d'une modification temporelle d'un état de charge électrique de l'électrode (I);
   d) le calcul d'amplitudes ($\hat{I}(f)$, $\hat{I}(2f)$) d'au moins deux composants de fréquence (f, 2f) au cours de la modification temporelle de l'état de charge électrique (I) ;
   e) la détermination, au moyen des amplitudes calculées ($\hat{I}(f)$, $\hat{I}(2f)$), d'au moins un paramètre ($\varepsilon$, $d_0$) qui entre dans la valeur d'une capacité électrique (C) de l'agencement se composant de l'électrode (2) et de l'objet (1);
   f) le calcul, à l'aide du paramètre déterminé ($\varepsilon$, $d_0$), de la capacité électrique (C) de l'agencement se composant de l'électrode (2) et de l'objet (1); et
   g) le calcul du potentiel électrique (U) résultant de la modification déterminée de l'état de charge électrique (I) et de la capacité calculée (C);

   **caractérisé par** les étapes suivantes :

   d1) la détermination d'une première amplitude ($\hat{I}(f)$) dans le cas d'une première fréquence (f);
   d2) la détermination d'une seconde amplitude ($\hat{I}(2f)$) dans le cas d'une seconde fréquence (2f) dont la valeur est un multiple entier de la valeur de la première fréquence (f); et
   e1) la détermination d'une distance de repos ($d_0$) de l'électrode (2) par rapport à l'objet (1), résultant du rapport (v) de la première amplitude ($\hat{I}(f)$) relativement à la seconde amplitude ($\hat{I}(2f)$).

2. Procédé selon la revendication 1, **caractérisé en ce que**, au cours de l'étape e), la détermination de l'au moins un paramètre ($\varepsilon$, $d_0$) se produit par un rapport mathématique et/ou par une courbe d'étalonnage (K1).

3. Procédé selon l'une des revendications précédentes, **caractérisé en ce que**, au cours de l'étape b), l'électrode (2) est décalée en oscillation mécanique de manière telle, que sa direction d'oscillation (r) s'étend parallèlement à une ligne de champ (E) électrique qui est provoquée par le potentiel électrique (U) de l'objet (1).

4. Procédé selon l'une quelconque des revendications précédentes, **caractérisé en ce que**, au cours de l'étape c), la détermination de la modification temporelle de l'état de charge électrique de l'électrode (2) se produit en mesurant un courant de transfert de charge (I).

5. Procédé selon l'une quelconque des revendications précédentes, **caractérisé en ce que**, au cours de l'étape g), le potentiel électrique (U) est calculé par un rapport mathématique et/ou par une courbe d'étalonnage (K2), à partir de la modification déterminée de l'état de charge électrique (I).

6. Procédé selon l'une quelconque des revendications précédentes, **caractérisé en ce que** le potentiel électrique (U) est variable dans le temps et peut être **caractérisé par** une fréquence d'oscillation électrique, et l'électrode (2), au cours de l'étape b), est décalée en oscillation mécanique de manière telle, que la fréquence d'oscillation mécanique (f) associée soit supérieure à la fréquence d'oscillation électrique.

7. Dispositif pour la détermination sans contact d'un potentiel électrique (U) d'un objet (1), comprenant :

   - une électrode (2) conçue en étant mécaniquement mobile en oscillation, électrode qui peut être agencée en étant physiquement à distance ($d_0$) de l'objet (1);
   - un appareil de mesure (3) qui est conçu dans le but de déterminer une modification temporelle d'un état de charge électrique (I) de l'électrode (2); et
   - un dispositif d'évaluation qui est conçu dans le but de calculer, au cours de la modification temporelle de l'état de charge électrique (I), des amplitudes ($\hat{I}(f)$, $\hat{I}(2f)$) d'au moins deux composants de fréquence (f, 2f), de déterminer, au moyen des amplitudes calculées ($\hat{I}(f)$, $\hat{I}(2f)$), au moins un paramètre ($\varepsilon$, $d_0$) qui entre dans la valeur d'une capacité électrique (C) de l'agencement se composant de l'électrode (2) et de l'objet (1), de calculer, à l'aide du paramètre déterminé ($\varepsilon$, $d_0$), la capacité électrique (C) de l'agencement se composant de l'électrode (2) et de l'objet (1), et de calculer le potentiel électrique (U) à partir de la modification déterminée de l'état de charge électrique (I) et de la capacité calculée (C),

**caractérisé en ce que**

- le dispositif d'évaluation est conçu dans le but de déterminer une première amplitude ($\hat{I}(f)$) dans le cas d'une première fréquence (f) et une seconde amplitude ($\hat{I}(2f)$) dans le cas d'une seconde fréquence (2f) dont la valeur est un multiple entier de la valeur de la première fréquence (f), et de déterminer une distance de repos ($d_0$) de l'électrode (2) par rapport à l'objet (1), à partir du rapport (v) de la première amplitude ($\hat{I}(f)$) relativement à la seconde amplitude ($\hat{I}(2f)$).

8. Dispositif selon la revendication 7, **caractérisé en ce que** l'électrode (2) est conçue comme une plaque électriquement conductrice qui est mobile en oscillation essentiellement suivant la direction (r) perpendiculaire à la plaque, et la plaque est connectée électriquement à l'appareil de mesure (3) qui est conçu comme un ampèremètre.

FIG 1

$U_0 = -I \cdot R$

EP 2 656 086 B1

FIG 2

EP 2 656 086 B1

FIG 3A

EP 2 656 086 B1

FIG 3B

EP 2 656 086 B1

FIG 4

EP 2 656 086 B1

FIG 5

EP 2 656 086 B1

**EP 2 656 086 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4205267 A
- US 2007065169 A1
- GB 2443280 A
- US 2007247166 A1